# EUROPEAN PATENT APPLICATION

(11) **EP 3 564 288 A1**
(43) Date of publication of application: **06.11.2019**
(21) Application number: 17832174.1
(22) Date of filing: 15.05.2017
(51) Int. Cl.: C08G 59/40, C08G 59/50, C08J 5/24, B32B 15/14, B32B 15/20, H05K 1/03, C08J 11/00, C08J 11/08

(54) **DEGRADABLE RESIN COMPOSITION, AND PREPREG AND LAMINATE PREPARED USING SAME AND RECYCLING METHOD THEREOF**

(30) Priority: 29.12.2016 CN 201611243657
(71) Applicant: Shengyi Technology Co., Ltd, Dongguan, Guangdong 523808 (CN)
(72) Inventor: JIE, Xingdi, Dongguan Guangdong 523808 (CN); LIN, Wei, Dongguan Guangdong 523808 (CN); YANG, Zhongqiang, Dongguan Guangdong 523808 (CN); XU, Yongjing, Dongguan Guangdong 523808 (CN)
(74) Representative: Plougmann Vingtoft a/s
(86) International application number: PCT/CN2017/084316
(87) International publication number: WO 2018/120588

(57) **Abstract**

The present invention relates to a low dielectric, high heat resistant and degradable resin composition, a prepreg and a laminate prepared using the same, and a recovery method thereof. The resin composition comprises an epoxy resin, a degradable curing agent and a non-degradable curing agent. The molar ratio of the reactive groups of the degradable curing agent to the non-degradable curing agent is (0.15-3):1. The present invention can obviously improve the heat resistance of the resin composition by adding the non-degradable curing agent on the basis of the addition of the degradable curing agent. Meanwhile, the present invention overcomes a technical bias, and proves that: when a non-degradable curing agent is added to a degradable curing agent system to co-cure epoxy, it is still possible to achieve recoverable degradation of copper clad laminates and printed circuit boards.

## Description

### Technical field

The present invention relates to the technical field of polymer materials, in particular to a degradable resin composition, a prepreg and a laminate prepared using the same, and a method for recovering the same, and more particularly, to a low dielectric, high heat resistant and degradable resin composition, a prepreg and a laminate prepared using the same, and a recovery method thereof.

### Background art

With the implementation of PCB lead-free technology, there is a requirement for further improving the heat resistance of copper clad laminates. The previous technologies for curing epoxy resins by dicyandiamide can no longer meet such a lead-free soldering process because of poor heat resistance.

Copper clad laminate is a raw material of printed circuit board (PCB). PCB is the basis of electronic industry, and is an indispensable important component of all kinds of electronic products. With the upgrading and updating of electronic products, there are more and more waste PCBs. Under natural conditions, harmful ingredients of these waste PCBs can enter the environment through water, air and soil and cause potential and long-term harm to the environment, and the harm is non-recoverable. Therefore, waste PCBs must be scientifically and reasonably recovered and waste PCBs recovery has gradually become a new industry.

Conventional PCBs are made by using thermosetting resin material and have reached the C-stage curing stage with characteristics of being insoluble and non-fusible, and thus it is the most difficult to dispose and recover PCB wastes among many wastes. The current methods for disposing large amount of waste PCBs include landfill, mechanical and chemical methods. The landfill method is carried out by directly burying waste PCBs in the soil, which damages the soil environment seriously and has now been banned by developed countries. The mechanical method is carried out as follows: waste PCBs are crushed into smaller particles by mechanical methods including cutting, grinding and other means, and then the PCB particles are separated according to different size and density. This more extensive recovery method has a low separation efficiency, and waste PCBs are likely to be contaminated by impurities which cannot be removed. Thus the recovered product can only be used as secondary fillers in less demanding applications. The chemical method includes heat treatment, solvent method, supercritical liquid method, etc., and often requires large equipments with high temperature and high pressure or strong corrosive liquids, and has high energy consumption and security risks. Moreover, if the PCB to be treated is halogen-containing, dioxin and other carcinogenic substances will be released at high temperature and form secondary pollution. Under the background of increasingly harsh environmental situations, there is an urgent need for a method for the treatment and recovery of PCB wastes, which has high separation efficiency and high value of recovery, and is green, cost appropriate and suitable for industrialization. This requires PCB itself is degradable.

On the other hand, with the development trend of high-speed and high-frequency of information processing and information transmission in recent years, there is a higher requirement on the dielectric properties of laminates used for printed circuit boards. Simply, laminate materials need low dielectric constant and dielectric loss to reduce signal delay, distortion and loss during high speed and high frequency transmission, as well as interference between signals. However, ordinary epoxy resins have high dielectric constant and dielectric loss, and are difficult to meet the requirement of high frequency applications. In recent years, in order to reduce the dielectric constant and dielectric loss of copper clad laminate products, researchers at home and abroad have made many attempts, for example using high performance resins such as polytetrafluoroethylene resin, bismaleimide-triazine resin, thermosetting polyphenylene ether, cyanate esters, polyetheretherketone and others, but their applications are constrained due to their processability, cost and other factors.

### Contents of the Invention

By studies the inventors have found that: degradability is imparted to boards by introducing a degradable curing agent into a resin composition; on the basis of this, the introduction of a non-degradable curing agent improves the heat resistance of the system under the premise of ensuring the degradability.

Based on this, the present invention provides a degradable resin composition, a prepreg and a laminate prepared using the same, and a recovery method thereof. Laminates for printed circuits produced using the resin composition have low dielectric properties and high heat resistance, and can achieve recoverable degradation of copper clad laminates and printed circuit boards.

The present inventors have conducted repeated and intensive studies to achieve the above object and as a result, have found that the above object can be attained by a resin composition obtained by appropriately mixing an epoxy resin, a degradable curing agent and a non-degradable curing agent, and optionally other materials.

That is, the present invention adopts the following technical solution: an epoxy resin composition comprises an epoxy resin, a degradable curing agent and a non-degradable curing agent; the molar ratio of the reactive groups of the degradable curing agent to the non-degradable curing agent is (0.15-3):1.

The present invention can obviously improve the heat resistance and the dielectric properties of the resin composition by adding the non-degradable curing agent into the degradable curing agent; meanwhile, the present invention, although the non-degradable curing agent is added into the degradable curing agent system to co-cure the epoxy, it still achieves recoverable degradation of copper clad laminates and printed circuit boards.

According to the present invention, the degradable curing agent comprises degradable isocyanate and/or degradable amine curing agent, for example the degradable curing agent may comprise only degradable isocyanate or only degradable amine curing agent or comprise a mixture of degradable isocyanate and degradable amine curing agent. Of course, the degradable curing agent may comprise other curing agents besides those described above. For other curing agents, those skilled in the art can make selections according to actual needs.

According to the present invention, the degradable isocyanate may have a general structural formula as shown in formula (I): 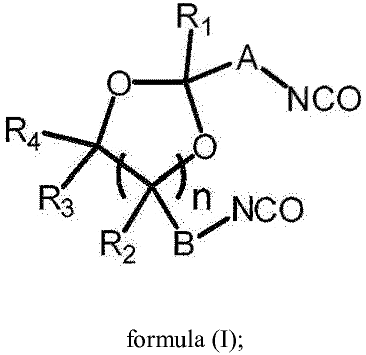
wherein n≥1, for example, n can be 1, 2, 3, 4 or 5, etc.;
wherein R₁, R₂, R₃ and R₄ are the same or different and are each independently selected from any one of hydrogen atom, alkyl, cycloalkyl, heterocyclic group, heterocycloalkyl, alkenyl, cycloalkenyl, alkynyl, aryl, heteroaryl, alkyleneoxyalkyl, alkyleneoxycycloalkyl, alkyleneoxyheterocyclic group, alkyleneoxyheterocycloalkyl, alkyleneoxyalkenyl, alkyleneoxycycloalkenyl, alkyleneoxyaryl, alkyleneoxyheteroaryl, cycloalkyleneoxyalkyl, cycloalkyleneoxycycloalkyl, cycloalkyleneoxyheterocyclic group, cycloalkyleneoxyheterocycloalkyl, cycloalkyleneoxyalkenyl, cycloalkyleneoxycycloalkenyl, cycloalkyleneoxyaryl, cycloalkyleneoxyheteroaryl, heterocycloalkyleneoxyalkyl, heterocycloalkyleneoxycycloalkyl, heterocycloalkyleneoxyheterocyclic group, heterocycloalkyleneoxyheterocycloalkyl, heterocycloalkyleneoxyalkenyl, heterocycloalkyleneoxycycloalkenyl, heterocycloalkyleneoxyaryl, heterocycloalkyleneoxyheteroaryl, aryleneoxyalkyl, aryleneoxycycloalkyl, aryleneoxyheterocyclic group, aryleneoxyheterocycloalkyl, aryleneoxyalkenyl, aryleneoxycycloalkenyl, aryleneoxyaryl, or aryleneoxyheteroaryl;
wherein R₃ and R₄ may be or not be in the same ring structure with the common adjacent carbon atom; R₁ and A may be or not be in the same ring structure with the common adjacent carbon atom; R₂ and B may be or not be in the same ring structure with the common adjacent carbon atom;
wherein A and B are the same or different and are each independently selected from any one of alkylene, alkylene heteroalkylene, alkenylene, alkenylene heteroalkenylene, alkylene heteroalkenylene, alkynylene, cycloalkylene, alkylene cycloalkylene, alkylene cycloalkylene alkylene, alkenylene cycloalkylene, alkenylene cycloalkylene alkenylene, alkylene cycloalkylene alkenylene, alkynylene cycloalkylene, alkynylene cycloalkylene alkynylene, heterocycloalkylene, alkylene heterocycloalkylene, alkylene heterocycloalkyl alkylene, alkenylene heterocycloalkylene, alkenylene heterocycloalkyl alkenylene, alkylene heterocycloalkyl alkenylene, alkynylene heterocycloalkylene, alkynylene heterocycloalkyl alkynylene, cycloalkenylene, alkylene cycloalkenylene, alkylene cycloalkenylene alkylene, alkenylene cycloalkenylene, alkenylene cycloalkenylene alkenylene, alkylene cycloalkenylene alkenylene, alkynylene cycloalkenylene, alkynylene cycloalkenylene alkynylene, heterocycloalkenylene, alkylene heterocycloalkenylene, alkylene heterocycloalkenyl alkylene, alkenylene heterocycloalkenylene, alkenylene heterocycloalkenyl alkenylene, alkylene heterocycloalkenyl alkenylene, alkynylene heterocycloalkenylene, alkynylene heterocycloalkenyl alkynylene, arylene, alkylene arylene, alkylene arylene alkylene, alkenylene arylene, alkenylene arylene alkenylene, alkylene arylene alkenylene, alkynylene arylene, alkynylene arylene alkynylene, heteroarylene, alkylene heteroarylene, alkylene heteroarylene alkylene, alkenylene heteroarylene, alkenylene heteroarylene alkenylene, alkylene heteroarylene alkenylene, alkynylene heteroarylene, alkynylene heteroarylene alkynylene, carbonyl or thiocarbonyl.

According to the present invention, the degradable isocyanate may have a general structural formula as shown in formula (II): 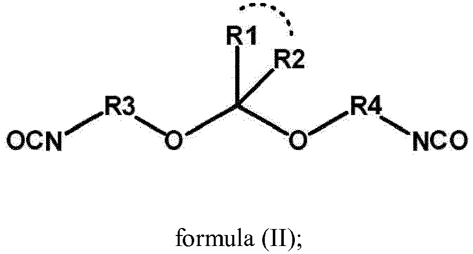
wherein R1, R2, R3 and R4 are the same or different and are each independently selected from any one of hydrogen atom, alkyl, cycloalkyl, heterocyclic group, heterocycloalkyl, alkenyl, cycloalkenyl, alkynyl, aryl, heteroaryl, alkyleneoxyalkyl, alkyleneoxycycloalkyl, alkyleneoxyheterocyclic group, alkyleneoxyheterocycloalkyl, alkyleneoxyalkenyl, alkyleneoxycycloalkenyl, alkyleneoxyaryl, alkyleneoxyheteroaryl, cycloalkyleneoxyalkyl, cycloalkyleneoxycycloalkyl, cycloalkyleneoxyheterocyclic group, cycloalkyleneoxyheterocycloalkyl, cycloalkyleneoxyalkenyl, cycloalkyleneoxycycloalkenyl, cycloalkyleneoxyaryl, cycloalkyleneoxyheteroaryl, heterocycloalkyleneoxyalkyl, heterocycloalkyleneoxycycloalkyl, heterocycloalkyleneoxyheterocyclic group, heterocycloalkyleneoxyheterocycloalkyl, heterocycloalkyleneoxyalkenyl, heterocycloalkyleneoxycycloalkenyl, heterocycloalkyleneoxyaryl, heterocycloalkyleneoxyheteroaryl, aryleneoxyalkyl, aryleneoxycycloalkyl, aryleneoxyheterocyclic group, aryleneoxyheterocycloalkyl, aryleneoxyalkenyl, aryleneoxycycloalkenyl, aryleneoxyaryl, or aryleneoxyheteroaryl;
wherein R3 and R4 may be or not be in the same ring structure with the common adjacent carbon atom; R1 and A may be or not be in the same ring structure with the common adjacent carbon atom; R2 and B may be or not be in the same ring structure with the common adjacent carbon atom;
wherein A and B are the same or different and are each independently selected from any one of alkylene, alkylene heteroalkylene, alkenylene, alkenylene heteroalkenylene, alkylene heteroalkenylene, alkynylene, cycloalkylene, alkylene cycloalkylene, alkylene cycloalkylene alkylene, alkenylene cycloalkylene, alkenylene cycloalkylene alkenylene, alkylene cycloalkylene alkenylene, alkynylene cycloalkylene, alkynylene cycloalkylene alkynylene, heterocycloalkylene, alkylene heterocycloalkylene, alkylene heterocycloalkyl alkylene, alkenylene heterocycloalkylene, alkenylene heterocycloalkyl alkenylene, alkylene heterocycloalkyl alkenylene, alkynylene heterocycloalkylene, alkynylene heterocycloalkyl alkynylene, cycloalkenylene, alkylene cycloalkenylene, alkylene cycloalkenylene alkylene, alkenylene cycloalkenylene, alkenylene cycloalkenylene alkenylene, alkylene cycloalkenylene alkenylene, alkynylene cycloalkenylene, alkynylene cycloalkenylene alkynylene, heterocycloalkenylene, alkylene heterocycloalkenylene, alkylene heterocycloalkenyl alkylene, alkenylene heterocycloalkenylene, alkenylene heterocycloalkenyl alkenylene, alkylene heterocycloalkenyl alkenylene, alkynylene heterocycloalkenylene, alkynylene heterocycloalkenyl alkynylene, arylene, alkylene arylene, alkylene arylene alkylene, alkenylene arylene, alkenylene arylene alkenylene, alkylene arylene alkenylene, alkynylene arylene, alkynylene arylene alkynylene, heteroarylene, alkylene heteroarylene, alkylene heteroarylene alkylene, alkenylene heteroarylene, alkenylene heteroarylene alkenylene, alkylene heteroarylene alkenylene, alkynylene heteroarylene, alkynylene heteroarylene alkynylene, carbonyl or thiocarbonyl.

In the present invention, the degradable curing agent may comprise only the degradable isocyanate having the general structural formula of formula (I) or formula (II), and may also comprise both of the two degradable isocyanates. When both of the two degradable isocyanates are comprised, the molar ratio of the two degradable isocyanates is 1:3-3:1, for example 3:1, 2:1, 1.5:1, 1:1, 1:2, 1:2.5 or 1:3, or specific point values between the above numerical values. The present invention is not exhaustive to enumerate the specific point values between the above numerical values due to the length of the text and consideration of conciseness.

In the present invention, when the degradable curing agent contains both of the two above-mentioned degradable isocyanates, if the proportion of the degradable isocyanate having the structure of formula (I) is greater than that of the degradable isocyanate having the structure of formula (II), the resin system will have better heat resistance; if the proportion of the degradable isocyanate having the structure of formula (II) is greater than that of the degradable isocyanate having the structure of formula (I), the resin system will have better dielectric properties.

The inventors have found that the NCO groups contained in the degradable isocyanate can react with epoxy groups to form isocyanurate and oxazolidone, so that the dielectric properties of the board are obviously improved. On this basis, further introduction of non-degradable curing agent can significantly improve the heat resistance of the system under the premise of ensuring the degradation.

According to the present invention, the degradable amine curing agent may have a general structural formula as shown in formula (III): 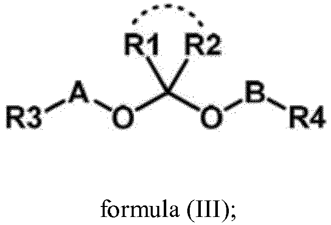
wherein R1 and R2 are the same or different and are each independently selected from any one of hydrogen atom, alkyl, cycloalkyl, heterocyclic group, heterocycloalkyl, alkenyl, cycloalkenyl, aryl, heteroaryl, alkyl heteroalkyl, alkynyl, alkylene, alkylene heteroalkylene, alkenylene, alkylene heteroalkenylene, alkynylene, or alkylene heteroalkynylene;
wherein R1 and R2 may be or not be in the same ring structure with the common adjacent carbon atom;
wherein A and B are the same or different and are each independently selected from any one of arylene, alkylene arylene, alkenylene arylene, alkynylene arylene, heteroarylene, alkylene heteroarylene, alkenylene heteroarylene, or alkynylene heteroarylene;
wherein R3 is selected from any one of 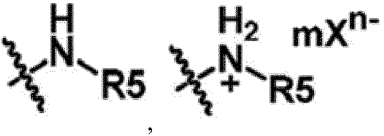 or 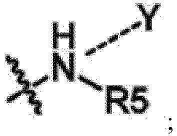
wherein R4 is selected from any one of 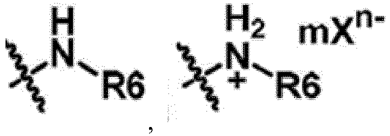 or 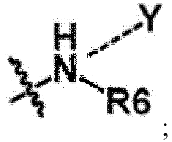
wherein R5 and R6 are the same or different and are each independently selected from any one of hydrogen atom, alkyl, cycloalkyl, heterocyclic group, heterocycloalkyl, alkenyl, cycloalkenyl, aryl, heteroaryl, alkyloxyalkyl or alkynyl;
wherein Xⁿ⁻ is selected from any one of C₁-C₁₀ aliphatic carboxylate anion, C₁-C₁₀ cycloaliphatic carboxylate anion, aromatic carboxylate anion, or heterocyclic aromatic carboxylate anion;
wherein n is 1, 2 or 3; m is 0.1-3, for example 0.1, 0.5, 1, 1.5, 2 or 3; and Y is any one of Lewis acids.

According to the present invention, the non-degradable amine curing agent may be any one selected from the group consisting of aliphatic amine curing agent, aromatic amine curing agent, cycloaliphatic amine curing agent and heterocyclic amine curing agent, or a mixture of at least two of them, wherein typical but non-limiting mixtures are: a mixture of aliphatic amine curing agent and aromatic amine curing agent, a mixture of cycloaliphatic amine curing agent and a heterocyclic amine curing agent.

Preferably, the aliphatic amine curing agent is any one selected from the group consisting of dicyandiamide, diethylenetriamine and derivatives thereof, triethylenetetramine and derivatives thereof, tetraethylenepentamine and derivatives thereof, polymethylenediamine, ethylenediamine, hexamethylenediamine, diethylpropylamine, aliphatic diamine with high carbon number, aliphatic amide polyamine and aromatic ring-containing aliphatic amine, or a mixture of at least two of them, wherein typical but non-limiting mixtures are: a mixture of diethylenetriamine and derivatives thereof and triethylenetetramine, a mixture of polymethylenediamine and ethylenediamine, a mixture of aliphatic amide polyamine and aromatic ring-containing aliphatic amine.

Preferably, the aromatic amine curing agent is any one selected from the group consisting of m-phenylenediamine, diaminodiphenylmethane, diaminodiphenylsulfone, arylether diamine and polyarylether diamine, or a mixture of at least two of them, wherein typical but non-limiting mixtures are: a mixture of m-phenylenediamine and diaminodiphenylmethane, a mixture of diaminodiphenylmethane and diaminodiphenylsulfone, a mixture of arylether diamine and polyarylene ether diamine.

Preferably, the cycloaliphatic amine curing agent is any one selected from the group consisting of menthane diamine, isophoronediamine, 1,3-bis(aminomethyl)cyclohexane and 4,4'-diaminodicyclohexylmethane and derivatives thereof, or a mixture of at least two of them, wherein typical but non-limiting mixtures are: a mixture of menthane diamine and isophoronediamine, a mixture of 1,3-bis(aminomethyl)cyclohexane and 4,4'-diaminodicyclohexylmethane.

Preferably, the heterocyclic amine curing agent is any one selected from the group consisting of diamine having a hydantoin ring structure, aminocyclotriphosphazene and phthalazinone, or a mixture of at least two of them, wherein typical but non-limiting mixtures are: a mixture of diamine having a hydantoin ring structure and aminocyclotriphosphazene, a mixture of aminocyclotriphosphazene and phthalazinone.

In the present invention, the molar ratio of the reactive groups of the degradable curing agent to the non-degradable curing agent is (0.15-3):1, for example 0.15:1, 0.25:1, 0.5:1, 0.75:1, 1:1, 1.2:1, 1.4:1, 1.5:1, 2:1, 2.25:1, 2.5:1, 2.8:1 or 3:1, or specific point values between the above numerical values. The present invention is not exhaustive to enumerate the specific point values between the above numerical values due to the length of the text and consideration of conciseness.

The present invention can ensure that the system can be degraded while improving the heat resistance by controlling the molar ratio of the reactive groups of the degradable curing agent to the non-degradable curing agent to be within the range of (0.15-3):1.

Preferably, when the molar ratio of the reactive groups of the degradable curing agent to the non-degradable curing agent is controlled at (0.25-0.5):1, an optimal balance of heat resistance and degradability can be achieved.

The present invention also provides an epoxy resin composition, which comprises the following components by weight parts:
(1) 30-80 parts of an epoxy resin and the degradable curing agent and the non-degradable curing agent as mentioned above;
(2) 0-40 parts of an inorganic filler;
(3) 20-50 parts of an organic solvent;
(4) 0.003-0.8 parts of a curing accelerator.

The term "comprise(s)/comprising" used in the present invention means that in addition to the components described, other components which give the epoxy resin composition different characteristics can also be included. In addition, the term "comprise(s)/comprising" used in the present invention may also be replaced by a closed description as "is/are /being" or "consist(s) of/consisting of'.

According to the present invention, the definitions for the degradable curing agent and the non-degradable curing agent are the same as those in the foregoing epoxy resin composition, and are not described in detail herein.

According to the present invention, by adding the degradable curing agent and the non-degradable curing agent to the epoxy resin together, the introduction of the degradable curing agent imparts degradability to boards and the introduction of the non-degradable curing agent improves the heat resistance of the system under the premise of ensuring the degradability; meanwhile, it also overcomes a technical bias, and proves that: when a non-degradable curing agent is added to a degradable curing agent system to co-cure epoxy, the system is still able to be recycled and degraded.

According to the present invention, the total amounts of the epoxy resin, the degradable curing agent and the non-degradable curing agent in the epoxy resin composition are 30-80 parts by weight, for example it can be 30 parts by weight, 32 parts by weight, 35 parts by weight, 40 parts by weight, 42 parts by weight, 45 parts by weight, 50 parts by weight, 55 parts by weight, 60 parts by weight, 65 parts by weight, 70 parts by weight, 75 parts by weight, or 80 parts by weight, or specific point values between the above numerical values. The present invention is not exhaustive to enumerate the specific point values between the above numerical values due to the length of the text and consideration of conciseness.

According to the present invention, the molar ratio of reactive groups in the degradable curing agent and the non-degradable curing agent to epoxy groups in the epoxy resin is (0.6-1.8):1, for example 0.6:1, 0.8:1, 1:1, 1.2:1, 1.5:1 or 1.8:1, or specific point values between the above numerical values. The present invention is not exhaustive to enumerate the specific point values between the above numerical values due to the length of the text and consideration of conciseness.

In the present invention, said "reactive groups in the degradable curing agent and the non-degradable curing agent" refers to the sum of the number of moles of isocyanate and active hydrogen.

According to the present invention, the content of the inorganic filler in the epoxy resin composition is 0-40 parts by weight, for example it can be 0 parts by weight, 5 parts by weight, 10 parts by weight, 12 parts by weight, 15 parts by weight, 18 parts by weight, 20 parts by weight, 25 parts by weight, 30 parts by weight, 35 parts by weight, 38 parts by weight or 40 parts by weight, or specific point values between the above numerical values. The present invention is not exhaustive to enumerate the specific point values between the above numerical values due to the length of the text and consideration of conciseness.

According to the present invention, the content of the organic solvent in the epoxy resin composition is 20-50 parts by weight, for example it can be 20 parts by weight, 22 parts by weight, 25 parts by weight, 30 parts by weight, 32 parts by weight, 35 parts by weight, 40 parts by weight, 45 parts by weight, 48 parts by weight or 50 parts by weight, or specific point values between the above numerical values. The present invention is not exhaustive to enumerate the specific point values between the above numerical values due to the length of the text and consideration of conciseness.

According to the present invention, the content of the curing accelerator in the epoxy resin composition is 0.003-0.8 parts by weight, for example it can be 0.003 parts by weight, 0.01 parts by weight, 0.05 parts by weight, 0.1 parts by weight, 0.2 parts by weight, 0.3 parts by weight, 0.4 parts by weight, 0.5 parts by weight, 0.6 parts by weight or 0.8 parts by weight, or specific point values between the above numerical values. The present invention is not exhaustive to enumerate the specific point values between the above numerical values due to the length of the text and consideration of conciseness.

According to the present invention, the epoxy resin may be any one selected from the group consisting of bisphenol A epoxy resin, bisphenol F epoxy resin, biphenyl epoxy resin, isocyanate modified epoxy resin, o-cresol epoxy resin, naphthalene epoxy resin, cycloaliphatic epoxy resin, brominated epoxy resin, resorcinol epoxy resin, polyethylene glycol epoxy resin, trifunctional epoxy resin, tetrafunctional epoxy resin, dicyclopentadiene epoxy resin and novolac epoxy resin, or a mixture of at least two of them, wherein typical but non-limiting mixtures are: a mixture of bisphenol A epoxy resin and bisphenol F epoxy resin, a mixture of o-cresol epoxy resin and naphthalene epoxy resin, and a mixture of brominated epoxy resin and resorcinol epoxy resin.

According to the present invention, the inorganic filler may be any one selected from the group consisting of aluminum hydroxide, boehmite, silica, talc powder, mica, barium sulfate, lithopone, calcium carbonate, wollastonite, kaolin, brucite, diatomaceous earth, bentonite and pumice powder, or a mixture of at least two of them, wherein typical but non-limiting mixtures are: a mixture of aluminum hydroxide and boehmite, a mixture of calcium carbonate and wollastonite, a mixture of brucite and diatomaceous earth.

According to the present invention, the organic solvent may be any one selected from the group consisting of acetone, butanone, cyclohexanone, dimethylformamide, dimethylacetamide, propylene glycol methyl ether, propylene glycol methyl ether acetate, ethylene glycol methyl ether, propylene glycol butyl ether, benzene, toluene, xylene and N-methylpyrrolidone, or a mixture of at least two of them, wherein typical but non-limiting mixtures are: a mixture of acetone and butanone, a mixture of cyclohexanone and dimethylformamide, a mixture of dimethylacetamide and propylene glycol methyl ether, and a mixture of toluene and xylene.

According to the present invention, the curing accelerator may be any one selected from the group consisting of 2-methylimidazole, 1-methylimidazole, 2-ethyl-4-methylimidazo le, 1-cyanoethyl-2-ethyl-4-methylimidazole, 2-phenylimidazole, 2-undecylimidazole, 2-phenyl-4-methylimidazole, tetramethylammonium bromide, lithium n-butoxide, aluminum chloride complex, quaternary ammonium polymer, 2,4,6-tris(dimethylaminomethyl)phenol, 1-allyl-3-methylimidazolium chloride and 1-ethyl-3-methylimidazolium acetate, or a mixture of at least two of them, wherein typical but non-limiting mixtures are: a mixture of 2-methylimidazole and 1-methylimidazole, a mixture of 1-cyanoethyl-2-ethyl-4-methylimidazole and 2-phenylimidazole, a mixture of 2-phenyl-4-methylimidazole and tetramethylammonium bromide, and a mixture of aluminum chloride complexe and quaternary ammonium polymer.

The prepreg of the present invention comprises a reinforcing material and the epoxy resin composition as mentioned above which is attached on the reinforcing material after impregnation and drying. The reinforcing material used in the present invention is not particularly limited, and may be an organic fiber, an inorganic fiber woven fabric or a non-woven fabric. The organic fiber may be aramid nonwoven fabric, and the inorganic fiber woven fabric may be E-glass fiber fabric, D-glass fiber fabric, S-glass fiber fabric, T glass fiber fabric, NE-glass fiber fabric or quartz fabric. The thickness of the reinforcing material is not particularly limited. The thickness of the woven or non-woven fabric is preferably 0.01 to 0.2 mm in view of good dimensional stability of the laminate, and is preferably subjected to splitting treatment and surface treatment by a silane coupling agent. In order to provide good water resistance and heat resistance, the silane coupling agent is preferably any one selected from the group consisting of epoxy silane coupling agent, amino silane coupling agent and vinyl silane coupling agent, or a mixture of at least two of them. The reinforcing material is impregnated with the epoxy resin composition described above and baked at 100-250°C for 1-15 minutes to obtain a prepreg.

The laminate of the present invention comprises at least one prepreg as mentioned above.

The copper clad laminate of the present invention comprises superimposed prepregs consisting of at least one prepreg as mentioned above and copper foils overlaying at one side or both sides of the superimposed prepregs.

The printed circuit board of the present invention comprises a laminate prepared by bonding one or two or more prepregs as described above together by heating and pressing and metal foils bonded to one or both sides of the laminate. The laminate is obtained by curing in a hot press at a curing temperature of 150-250°C and a curing pressure of 10-60 kg/cm². The metal foil is a copper foil, a nickel foil, an aluminum foil and a SUS foil, etc., and the material thereof is not limited.

The present invention provides a method for recovering the copper clad laminate and printed circuit board as described above, comprising the steps of:
(1) putting the printed circuit board into lye and then heating it to 75-80°C to remove green oil on the printed circuit board;
(2) putting the printed circuit board with green oil removed into an acidic organic solvent to obtain some components and metals after soaking and heating, wherein the obtained components and metals can be reused after being cleaned respectively;
or, (2') etching the printed circuit board with green oil removed to obtain a copper ion recovery solution, and then putting the resulting substrate of copper clad laminate into an acidic organic solvent, soaking and heating to decompose epoxy resin composition to obtain a glass fabric and a decomposition product solution, wherein the obtained glass fabric can be reused after being cleaned;
optionally, (3') filtering the decomposition product solution of step (2') to obtain degradation liquid and solid fraction, adding alkali to the obtained degradation liquid for neutralization to precipitate the resin, and then filtering and separating to obtain a degraded resin which can be reused;
optionally, (4') separating each component of the solid fraction obtained in the step (3 ') based on different sizes thereof by sieves with different apertures, or based on different densities thereof by forming floating layer(s) and subsidence layer(s) in a same liquid due to different buoyancies, to separate filler, a small amount of powder and insoluble particles in the solid fraction, wherein the obtained filler can be reused after being cleaned.

In the present invention, if the copper clad laminate and the printed circuit board are to be completely recovered, all the above steps need to be performed; if they are not to be completely recovered, only some of the steps may be used. For example, if only the glass fabric is to be recovered, only steps (1), (2) and (2') are needed, and the subsequent steps are not needed.

Compared with the prior art, the present invention has at least the following beneficial effects:
The prepreg and the printed circuit board prepared by using the resin composition of the present invention have excellent heat resistance (T288 reaching a maximum of 6 minutes), a glass transition temperature which can reach above 133°C, and have low dielectric properties, a Dk value of 3.85-4.30, a Df value of 0.014-0.021, and can achieve recoverable degradation of copper clad laminates and printed circuit boards.

### Embodiments

The technical solutions of the present invention are further explained by combining with the following embodiments.

The following descriptions are specific embodiments of the examples of the present invention, and it should be noted that those skilled in the art can make a number of improvements and modifications without departing from the principles of the embodiments of the present invention, and these improvements and modifications are also considered to fall within the protection scope of the present invention.

The embodiments of the present invention will be described in further detail with reference to the following examples. The embodiment of the present invention is not limited to the following specific examples. It is possible to appropriately change the examples without changing the scope of the claims.

### Examples

(1) Epoxy resin, degradable curing agent, non-degradable curing agent, inorganic filler, organic solvent and curing accelerator were rationed according to the contents shown in the following Tables 1-2;
(2) The above components were formulated into a glue solution having a solid content of 70%, and were mixed to obtain a well-dispersed glue solution; a 2116 glass fiber fabric was immersed in the composition for gluing, and the resultant was baked in an oven at a temperature of 155°C for 5 min to obtain a prepreg;
(3) Several sheets of the above prepregs were superimposed, with one 35µm electrolytic copper foil overlaid on the uppermost and lowermost surfaces of the superimposed prepregs respectively; and then the resultant was hot pressed in a vacuum press machine in accordance with established procedures at 180 °C and a pressure of 35kgf/cm² for 90 min, to obtain a double-side copper clad laminate with a thickness of 0.8mm.

### Comparative Examples

(1) Epoxy resin, degradable curing agent, non-degradable curing agent, inorganic filler, organic solvent and curing accelerator were rationed according to the contents shown in the following Table 3;
Steps (2) - (3) are the same as those in the above examples.

Performance tests are performed to the Examples and Comparative Examples and the results are shown in Table 4.

The materials and their trademark informations involved in the examples and comparative examples are as follows.
(A) Epoxy resin
   NC-3000H: NIPPON KAYAKU, biphenyl epoxy resin, epoxy equivalent 294
   HP-7200HHH: DIC, DCPD epoxy resin, epoxy equivalent 288
(B) Curing agent
   Degradable isocyanate I: Adesso Advanced Materials
   Degradable isocyanate II: Adesso Advanced Materials
   ACP-2004: Adesso Advanced Materials, degradable amine curing agent, active hydrogen equivalent 57.5
   DICY: Ningxia XiaRong, non-degradable amine curing agent, active hydrogen equivalent 21
   DOW92741: Dow Chemical, phosphorus-containing phenolic curing agent, hydroxyl equivalent 325-375
(C) Inorganic filler: admatechs-2050MB
(D) Organic solvent
   MEK: butanone
   DMF: dimethylformamide
(E) Curing accelerator
   2E4MZ: Shikoku Chemicals Corporation, 2-ethyl-4-methyl imidazole
   UR200: Degussa AG, organic urea accelerator

**Table 1**

| | Example 1 | Example 2 | Example 3 | Example 4 | Example 5 | Example 6 |
|---|---|---|---|---|---|---|
| NC-3000H | 960 | 960 | 960 | 960 | 960 | 576 |
| HP-7200HHH | 0 | 0 | 0 | 0 | 0 | 0 |
| Degradable isocyanate I | 92 | 0 | 46 | 0 | 92 | 46 |
| Degradable isocyanate II | 0 | 79 | 40 | 0 | 79 | 40 |
| ACP-2004 | 0 | 0 | 0 | 57.5 | 57.5 | 0 |
| DICY | 63 | 63 | 63 | 63 | 21 | 63 |
| DOW92741 | 0 | 0 | 0 | 0 | 0 | 0 |
| 2050MB | 124 | 122 | 123 | 120 | 138 | 81 |
| MEK | 269 | 266 | 268 | 261 | 301 | 175 |
| DMF | 269 | 266 | 268 | 261 | 301 | 175 |
| 2E4MI | 1.115 | 1.102 | 1.109 | 1.0805 | 1.246 | 0.725 |
| UR200 | 1.115 | 1.102 | 1.109 | 1.0805 | 1.246 | 0.725 |

**Table 2**

| | Example 7 | Example 8 | Example 9 | Example 10 | Example 11 | Example 12 | Example 13 |
|---|---|---|---|---|---|---|---|
| NC-3000H | 0 | 960 | 960 | 960 | 480 | 960 | 0 |
| HP-7200HHH | 960 | 0 | 0 | 0 | 480 | 0 | 960 |
| Degradable isocyanate I | 92 | 0 | 46 | 46 | 46 | 92 | 46 |
| Degradable isocyanate II | 0 | 79 | 40 | 40 | 40 | 0 | 40 |
| ACP-2004 | 0 | 57.5 | 0 | 0 | 0 | 57.5 | 57.5 |
| DICY | 63 | 42 | 42 | 63 | 63 | 42 | 42 |
| DOW92741 | 0 | 0 | 350 | 0 | 0 | 0 | 0 |
| 2050MB | 124 | 137 | 160 | 0 | 123 | 140 | 129 |
| MEK | 269 | 298 | 347 | 241 | 268 | 304 | 280 |
| DMF | 269 | 298 | 347 | 241 | 268 | 304 | 280 |
| 2E4MI | 1.115 | 1.233 | 1.438 | 1.109 | 1.109 | 1.259 | 1.161 |
| UR200 | 1.115 | 1.233 | 1.438 | 1.109 | 1.109 | 1.259 | 1.161 |

**Table 3**

| | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 | Comp. Ex. 9 | Comp. Ex. 10 |
|---|---|---|---|---|---|---|---|---|---|---|
| NC-3000H | 960 | 960 | 960 | 960 | 960 | 960 | 2640 | 1440 | 1680 | 960 |
| Degradable isocyanate I | 184 | 0 | 368 | 0 | 122.67 | 0 | | 0 | 0 | 0 |
| Degradable isocyanate II | 158 | 316 | 0 | 0 | 105.33 | 0 | 0 | 0 | 0 | 0 |
| ACP-2004 | 0 | 0 | 0 | 230 | 76.67 | 0 | 57.5 | 345 | 57.5 | 230 |
| DICY | 0 | 0 | 0 | 0 | 0 | 84 | 210 | 21 | 210 | 21 |
| 2050MB | 144.67 | 142 | 148 | 132.22 | 140.52 | 116 | 323.06 | 200.67 | 210 | 132 |
| MEK | 314.49 | 308 | 320 | 287.44 | 305.48 | 252.17 | 702.30 | 436.23 | 457 | 287 |
| DMF | 314.49 | 308 | 320 | 287.44 | 305.48 | 252.17 | 702.30 | 436.23 | 457 | 287 |
| 2E4MI | 1.302 | 1.276 | 1.328 | 1.19 | 1.265 | 1.044 | 2.908 | 1.806 | 1.890 | 1.190 |
| UR200 | 1.302 | 1.276 | 1.328 | 1.19 | 1.265 | 1.044 | 2.908 | 1.806 | 1.890 | 1.190 |

**Table 4**

| | T288 (min) | Tg (DSC, °C) | Dk (1GHz SPDR) | Df (1GHz SPDR) | Degradation time (h) |
|---|---|---|---|---|---|
| Ex. 1 | 3 | 160 | 3.98 | 0.016 | 15 |
| Ex. 2 | 2.6 | 155 | 3.89 | 0.015 | 14 |
| Ex. 3 | 2.8 | 157 | 3.91 | 0.015 | 15 |
| Ex. 4 | 1.8 | 139 | 4.28 | 0.018 | 12 |
| Ex. 5 | 1.0 | 158 | 3.89 | 0.014 | 10 |
| Ex. 6 | 1.8 | 133 | 3.85 | 0.015 | 12 |
| Ex. 7 | 4 | 165 | 3.88 | 0.015 | 18 |
| Ex. 8 | 1.3 | 155 | 3.87 | 0.014 | 10 |
| Ex. 9 | 6 | 157 | 3.92 | 0.019 | Partial degradation (resin and glass fiber fabric cannot be completely separated) |
| Ex. 10 | 3.0 | 156 | 4.30 | 0.021 | 15 |
| Ex. 11 | 3.3 | 160 | 3.80 | 0.014 | 17 |
| Ex. 12 | 1.5 | 158 | 3.90 | 0.015 | 11 |
| Ex. 13 | 1.4 | 162 | 3.80 | 0.013 | 11 |
| Comp. Ex. 1 | 0 | 161 | 3.80 | 0.015 | 8 |
| Comp. Ex. 2 | 0 | 158 | 3.78 | 0.014 | 7 |
| Comp. Ex. 3 | 0 | 162 | 3.81 | 0.015 | 7 |
| Comp. Ex. 4 | 0 | 135 | 4.30 | 0.018 | 6 |
| Comp. Ex. 5 | 0 | 163 | 3.96 | 0.015 | 7 |
| Comp. Ex. 6 | 2 | 140 | 4.00 | 0.019 | No degradation |
| Comp. Ex. 7 | 2 | 140 | 4.00 | 0.019 | No degradation |
| Comp. Ex. 8 | 0.1 | 136 | 4.26 | 0.018 | 6 |
| Comp. Ex. 9 | 2.1 | 141 | 4.00 | 0.019 | No degradation |
| Comp. Ex. 10 | 0 | 125 | 4.10 | 0.020 | 6 |

Test methods for the above properties are as follows:
(1) Glass transition temperature (Tg) was tested using DMA according to DMA test method prescribed in IPC-TM-650 2.4.24.
(2) Dielectric constant and dielectric loss factor were measured according to the SPDR method.
(3) T288 was tested by TMA according to T300 test method prescribed in IPC-TM-650 2.4.24.1.
(4) Degradation time was tested as follow: PCB or CCL to be degraded was placed in a degradation solution; when the temperature was raised to the specified temperature (100°C), the time was recorded as t1; when no resin residue was seen on the glass fiber fabric, the time was recorded as t2; and the degradation time t = t2-t1.

From Table 1 to Table 4 we can see the following points.
(1) Under the condition that the molar ratios of epoxy resin to curing agent are the same, Example 3 is compared with Comparative Example 1, and it can be seen that the board of Example 3, which uses two degradable curing agents of degradable isocyanate I and degradable isocyanate II and a non-degradable curing agent to co-cure epoxy resin, has better heat resistance compared with the board of Comparative Example 1, which only uses these two degradable curing agents to cure epoxy resin;
   When Example 2 is compared with Comparative Example 2, it can be seen that the board of Example 2, which uses a degradable curing agent of degradable isocyanate II and a non-degradable curing agent to co-cure epoxy resin, has better heat resistance compared with the board of Comparative Example 2, which only uses a degradable curing agent of degradable isocyanate II;
   When Example 1 is compared with Comparative Example 3, it can be seen that the board of Example 1, which uses a degradable curing agent of degradable isocyanate I and a non-degradable curing agent to co-cure epoxy resin, has better heat resistance compared with the board of Comparative Example 3, which only uses a degradable curing agent of degradable isocyanate I;
   When Example 4 is compared with Comparative Example 4, it can be seen that the board of Example 4, which uses a degradable amine curing agent and a non-degradable curing agent to co-cure epoxy resin, has better heat resistance and higher glass transition temperature compared with the board of Comparative Example 4, which only uses a degradable amine curing agent;
   When Example 5 is compared with Comparative Example 5, it can be seen that the board of Example 5, which uses three degradable curing agents of degradable isocyanate I, degradable isocyanate II and degradable amine curing agent and a non-degradable curing agent to co-cure epoxy resin, has better heat resistance and dielectric properties compared with the board of Comparative Example 5, which only uses these three degradable curing agents;
   When Examples 1-3 are compared with Comparative Example 6, it can be seen that the boards of Examples 1-3, which use a degradable curing agent and a non-degradable curing agent to co-cure epoxy resin, have better heat resistance and dielectric properties and higher glass transition temperature compared with the board of Comparative Example 6, which only uses a non-degradable curing agent;
   Based on the above comparison results, it can be seen that the degradable curing agent and non-degradable curing agent in the present invention have a synergistic effect which enables the boards to have more excellent heat resistance, higher glass transition temperature and better dielectric properties.
(2) Example 4, which uses a molar ratio of the reactive groups of degradable curing agent to non-degradable curing agent of 0.3:1 for curing epoxy resin, is compared with Comparative Examples 9-10, which use molar ratios of the reactive groups of degradable curing agent to non-degradable curing agent of 0.1:1 or 4:1 respectively. It can be seen that the cured product of Example 4 has a better balance between heat resistance and degradability; when the molar ratio of the reactive groups of degradable curing agent to non-degradable curing agent is 0.1:1, the cured product cannot be degraded; and when the molar ratio is 4:1, the system has a poor heat resistance, and a T288 of 0 min, and directly melts.

This also shows that the molar ratio of the reactive groups of the degradable curing agent to the non-degradable curing agent used in the present invention should be controlled within the range of (0.15-3):1, and this molar ratio range enables the cured product has both heat resistance and degradability, and better overall performances.

It can be seen from the above results that the prepreg and the printed circuit board prepared by using the resin composition of the present invention have excellent heat resistance (T288 reaching a maximum of 6 minutes), a glass transition temperature which can reach above 133°C, and have low dielectric properties, a Dk value of 3.85-4.30, a Df value of 0.014-0.021, and can achieve recoverable degradation of copper clad laminate and printed circuit board.

The applicant states that: the present invention describes the detailed technological equipment and process by the aforesaid examples, but the present invention is not limited by the aforesaid detailed technological equipment and process. That is to say, it does not mean that the present invention cannot be fulfilled unless relying on the aforesaid detailed technological equipment and process. Those skilled in the art shall know that, any amendments, equivalent changes to the product materials of the present invention, additions of auxiliary ingredients, and selections of any specific modes and the like all fall within the protection scope and disclosure scope of the present invention.

## Claims

1. An epoxy resin composition, comprising an epoxy resin, a degradable curing agent and a non-degradable curing agent; wherein the molar ratio of the reactive groups of the degradable curing agent to the non-degradable curing agent is (0.15-3):1.

2. The epoxy resin composition of claim 1, **characterized in that** the degradable curing agent comprises degradable isocyanate and/or degradable amine curing agent;
preferably, the non-degradable curing agent includes any one selected from the group consisting of non-degradable amine curing agent, phenolic curing agent, anhydride curing agent, ester curing agent, imidazole curing agent and thiol, or a mixture of at least two of them.

3. The epoxy resin composition of claim 2, **characterized in that** the degradable isocyanate comprises a general structural formula as shown in formula (I): 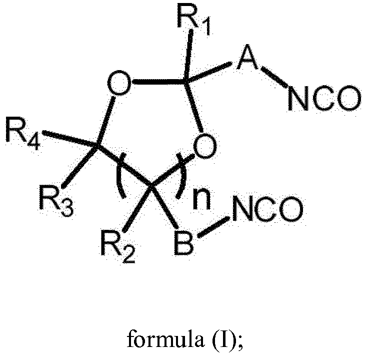
wherein n≥1;
wherein R₁, R₂, R₃ and R₄ are the same or different and are each independently selected from any one of hydrogen atom, alkyl, cycloalkyl, heterocyclic group, heterocycloalkyl, alkenyl, cycloalkenyl, alkynyl, aryl, heteroaryl, alkyleneoxyalkyl, alkyleneoxycycloalkyl, alkyleneoxyheterocyclic group, alkyleneoxyheterocycloalkyl,
alkyleneoxyalkenyl, alkyleneoxycycloalkenyl, alkyleneoxyaryl, alkyleneoxyheteroaryl, cycloalkyleneoxyalkyl, cycloalkyleneoxycycloalkyl, cycloalkyleneoxyheterocyclic group, cycloalkyleneoxyheterocycloalkyl, cycloalkyleneoxyalkenyl, cycloalkyleneoxycycloalkenyl, cycloalkyleneoxyaryl, cycloalkyleneoxyheteroaryl, heterocycloalkyleneoxyalkyl, heterocycloalkyleneoxycycloalkyl, heterocycloalkyleneoxyheterocyclic group, heterocycloalkyleneoxyheterocycloalkyl, heterocycloalkyleneoxyalkenyl, heterocycloalkyleneoxycycloalkenyl, heterocycloalkyleneoxyaryl, heterocycloalkyleneoxyheteroaryl, aryleneoxyalkyl, aryleneoxycycloalkyl, aryleneoxyheterocyclic group, aryleneoxyheterocycloalkyl, aryleneoxyalkenyl, aryleneoxycycloalkenyl, aryleneoxyaryl, or aryleneoxyheteroaryl;
wherein R₃ and R₄ may be or not be in the same ring structure with the common adjacent carbon atom; R₁ and A may be or not be in the same ring structure with the common adjacent carbon atom; R₂ and B may be or not be in the same ring structure with the common adjacent carbon atom;
wherein A and B are the same or different and are each independently selected from any one of alkylene, alkylene heteroalkylene, alkenylene, alkenylene heteroalkenylene, alkylene heteroalkenylene, alkynylene, cycloalkylene, alkylene cycloalkylene, alkylene cycloalkylene alkylene, alkenylene cycloalkylene, alkenylene cycloalkylene alkenylene, alkylene cycloalkylene alkenylene, alkynylene cycloalkylene, alkynylene cycloalkylene alkynylene, heterocycloalkylene, alkylene heterocycloalkylene, alkylene heterocycloalkyl alkylene, alkenylene heterocycloalkylene, alkenylene heterocycloalkyl alkenylene, alkylene heterocycloalkyl alkenylene, alkynylene heterocycloalkylene, alkynylene heterocycloalkyl alkynylene, cycloalkenylene, alkylene cycloalkenylene, alkylene cycloalkenylene alkylene, alkenylene cycloalkenylene, alkenylene cycloalkenylene alkenylene, alkylene cycloalkenylene alkenylene, alkynylene cycloalkenylene, alkynylene cycloalkenylene alkynylene, heterocycloalkenylene, alkylene heterocycloalkenylene, alkylene heterocycloalkenyl alkylene, alkenylene heterocycloalkenylene, alkenylene heterocycloalkenyl alkenylene, alkylene heterocycloalkenyl alkenylene, alkynylene heterocycloalkenylene, alkynylene heterocycloalkenyl alkynylene, arylene, alkylene arylene, alkylene arylene alkylene, alkenylene arylene, alkenylene arylene alkenylene, alkylene arylene alkenylene, alkynylene arylene, alkynylene arylene alkynylene, heteroarylene, alkylene heteroarylene, alkylene heteroarylene alkylene, alkenylene heteroarylene, alkenylene heteroarylene alkenylene, alkylene heteroarylene alkenylene, alkynylene heteroarylene, alkynylene heteroarylene alkynylene, carbonyl or thiocarbonyl.

4. The epoxy resin composition of claim 2, **characterized in that** the degradable isocyanate comprises a general structural formula as shown in formula (II): 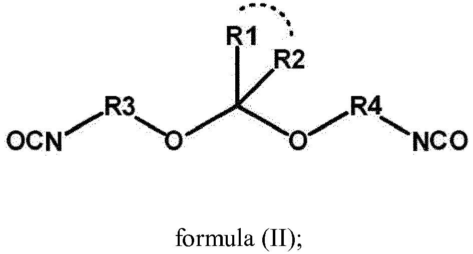
wherein R1, R2, R3 and R4 are the same or different and are each independently selected from any one of hydrogen atom, alkyl, cycloalkyl, heterocyclic group, heterocycloalkyl, alkenyl, cycloalkenyl, alkynyl, aryl, heteroaryl, alkyleneoxyalkyl, alkyleneoxycycloalkyl, alkyleneoxyheterocyclic group, alkyleneoxyheterocycloalkyl, alkyleneoxyalkenyl, alkyleneoxycycloalkenyl, alkyleneoxyaryl, alkyleneoxyheteroaryl, cycloalkyleneoxyalkyl, cycloalkyleneoxycycloalkyl, cycloalkyleneoxyheterocyclic group, cycloalkyleneoxyheterocycloalkyl, cycloalkyleneoxyalkenyl, cycloalkyleneoxycycloalkenyl, cycloalkyleneoxyaryl, cycloalkyleneoxyheteroaryl, heterocycloalkyleneoxyalkyl, heterocycloalkyleneoxycycloalkyl, heterocycloalkyleneoxyheterocyclic group, heterocycloalkyleneoxyheterocycloalkyl, heterocycloalkyleneoxyalkenyl, heterocycloalkyleneoxycycloalkenyl, heterocycloalkyleneoxyaryl, heterocycloalkyleneoxyheteroaryl, aryleneoxyalkyl, aryleneoxycycloalkyl, aryleneoxyheterocyclic group, aryleneoxyheterocycloalkyl, aryleneoxyalkenyl, aryleneoxycycloalkenyl, aryleneoxyaryl, or aryleneoxyheteroaryl;
wherein R3 and R4 may be or not be in the same ring structure with the common adjacent carbon atom; R1 and A may be or not be in the same ring structure with the common adjacent carbon atom; R2 and B may be or not be in the same ring structure with the common adjacent carbon atom;
wherein A and B are the same or different and are each independently selected from any one of alkylene, alkylene heteroalkylene, alkenylene, alkenylene heteroalkenylene, alkylene heteroalkenylene, alkynylene, cycloalkylene, alkylene cycloalkylene, alkylene cycloalkylene alkylene, alkenylene cycloalkylene, alkenylene cycloalkylene alkenylene, alkylene cycloalkylene alkenylene, alkynylene cycloalkylene, alkynylene cycloalkylene alkynylene, heterocycloalkylene, alkylene heterocycloalkylene, alkylene heterocycloalkyl alkylene, alkenylene heterocycloalkylene, alkenylene heterocycloalkyl alkenylene, alkylene heterocycloalkyl alkenylene, alkynylene heterocycloalkylene, alkynylene heterocycloalkyl alkynylene, cycloalkenylene, alkylene cycloalkenylene, alkylene cycloalkenylene alkylene, alkenylene cycloalkenylene, alkenylene cycloalkenylene alkenylene, alkylene cycloalkenylene alkenylene, alkynylene cycloalkenylene, alkynylene cycloalkenylene alkynylene, heterocycloalkenylene, alkylene heterocycloalkenylene, alkylene heterocycloalkenyl alkylene, alkenylene heterocycloalkenylene, alkenylene heterocycloalkenyl alkenylene, alkylene heterocycloalkenyl alkenylene, alkynylene heterocycloalkenylene, alkynylene heterocycloalkenyl alkynylene, arylene, alkylene arylene, alkylene arylene alkylene, alkenylene arylene, alkenylene arylene alkenylene, alkylene arylene alkenylene, alkynylene arylene, alkynylene arylene alkynylene, heteroarylene, alkylene heteroarylene, alkylene heteroarylene alkylene, alkenylene heteroarylene, alkenylene heteroarylene alkenylene, alkylene heteroarylene alkenylene, alkynylene heteroarylene, alkynylene heteroarylene alkynylene, carbonyl or thiocarbonyl.

5. The epoxy resin composition of any one of claims 2-4, **characterized in that** the degradable amine curing agent comprises a general structural formula as shown in formula (III): 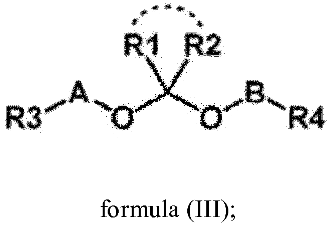
wherein R1 and R2 are the same or different and are each independently selected from any one of hydrogen atom, alkyl, cycloalkyl, heterocyclic group, heterocycloalkyl, alkenyl, cycloalkenyl, aryl, heteroaryl, alkyl heteroalkyl, alkynyl, alkylene, alkylene heteroalkylene, alkenylene, alkylene heteroalkenylene, alkynylene, or alkylene heteroalkynylene;
wherein R1 and R2 may be or not be in the same ring structure with the common adjacent carbon atom;
wherein A and B are the same or different and are each independently selected from any one of arylene, alkylene arylene, alkenylene arylene, alkynylene arylene, heteroarylene, alkylene heteroarylene, alkenylene heteroarylene, or alkynylene heteroarylene;
wherein R3 is selected from any one of 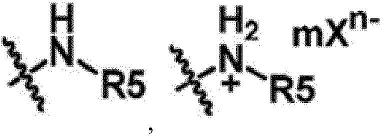 or 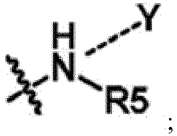
wherein R4 is selected from any one of 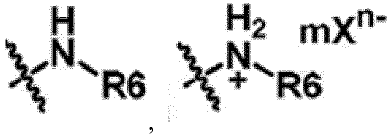 or 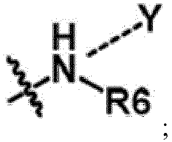
wherein R5 and R6 are the same or different and are each independently selected from any one of hydrogen atom, alkyl, cycloalkyl, heterocyclic group, heterocycloalkyl, alkenyl, cycloalkenyl, aryl, heteroaryl, alkyloxyalkyl or alkynyl;
wherein Xⁿ⁻ is selected from any one of C₁-C₁₀ aliphatic carboxylate anion, C₁-C₁₀ cycloaliphatic carboxylate anion, aromatic carboxylate anion, or heterocyclic aromatic carboxylate anion;
wherein n is 1, 2 or 3; m is 0.1-3; and Y is any one of Lewis acids.

6. The epoxy resin composition of any one of claims 2-5, **characterized in that** the non-degradable amine curing agent is any one selected from the group consisting of aliphatic amine curing agent, aromatic amine curing agent, cycloaliphatic amine curing agent and heterocyclic amine curing agent, or a mixture of at least two of them;
preferably, the aliphatic amine curing agent is any one selected from the group consisting of dicyandiamide, diethylenetriamine and derivatives thereof, triethylenetetramine and derivatives thereof, tetraethylenepentamine and derivatives thereof, polymethylenediamine, ethylenediamine, hexamethylenediamine, diethylpropylamine, aliphatic diamine with high carbon number, aliphatic amide polyamine and aromatic ring-containing aliphatic amine, or a mixture of at least two of them;
preferably, the aromatic amine curing agent is any one selected from the group consisting of m-phenylenediamine, diaminodiphenylmethane, diaminodiphenylsulfone, arylether diamine and polyarylether diamine, or a mixture of at least two of them;
preferably, the cycloaliphatic amine curing agent is any one selected from the group consisting of menthane diamine, isophoronediamine, 1,3-bis(aminomethyl)cyclohexane and 4,4'-diaminodicyclohexylmethane and derivatives thereof, or a mixture of at least two of them;
preferably, the heterocyclic amine curing agent is any one selected from the group consisting of diamine having a hydantoin ring structure, aminocyclotriphosphazene and phthalazinone, or a mixture of at least two of them.

7. An epoxy resin composition, **characterized in** comprising the following components by weight parts:
(1) 30-80 parts of an epoxy resin and the degradable curing agent and the non-degradable curing agent of any one of claims 1-6;
(2) 0-40 parts of an inorganic filler;
(3) 20-50 parts of an organic solvent;
(4) 0.003-0.8 parts of a curing accelerator.

8. The epoxy resin composition of any one of claims 1-7, **characterized in that** the molar ratio of reactive groups in the degradable curing agent and the non-degradable curing agent to epoxy groups in the epoxy resin is (0.6-1.8):1;
preferably, the epoxy resin is any one selected from the group consisting of bisphenol A epoxy resin, bisphenol F epoxy resin, biphenyl epoxy resin, isocyanate modified epoxy resin, o-cresol epoxy resin, naphthalene epoxy resin, cycloaliphatic epoxy resin, brominated epoxy resin, phosphorus-containing epoxy resin, resorcinol epoxy resin, polyethylene glycol epoxy resin, trifunctional epoxy resin, tetrafunctional epoxy resin, dicyclopentadiene epoxy resin and novolac epoxy resin, or a mixture of at least two of them.

9. The epoxy resin composition of claim 7, **characterized in that** the inorganic filler is any one selected from the group consisting of aluminum hydroxide, boehmite, silica, talc powder, mica, barium sulfate, lithopone, calcium carbonate, wollastonite, kaolin, brucite, diatomaceous earth, bentonite and pumice powder, or a mixture of at least two of them;
perferably, the organic solvent is any one selected from the group consisting of acetone, butanone, cyclohexanone, dimethylformamide, dimethylacetamide, propylene glycol methyl ether, propylene glycol methyl ether acetate, ethylene glycol methyl ether, propylene glycol butyl ether, benzene, toluene, xylene and N-methylpyrrolidone, or a mixture of at least two of them;
perferably, the curing accelerator is any one selected from the group consisting of 2-methylimidazole, 1-methylimidazole, 2-ethyl-4-methylimidazole, 1-cyanoethyl-2-ethyl-4-methylimidazole, 2-phenylimidazole, 2-undecylimidazole, 2-phenyl-4-methylimidazole, tetramethylammonium bromide, lithium n-butoxide, aluminum chloride complex, quaternary ammonium polymer, 2,4,6-tris(dimethylaminomethyl)phenol, 1-allyl-3-methylimidazolium chloride and 1-ethyl-3-methylimidazolium acetate, or a mixture of at least two of them.

10. A prepreg, comprising a reinforcing material and the epoxy resin composition of any one of claims 1-9 which is attached on the reinforcing material after impregnation and drying.

11. A laminate, comprising at least one prepreg of claim 10.

12. A copper clad laminate, comprising superimposed prepregs consisting of at least one prepreg of claim 10 and copper foils overlaying at one side or both sides of the superimposed prepregs.

13. A printed circuit board, comprising at least one prepreg of claim 10.

14. A method for recovering the printed circuit board of claim 13, **characterized in** comprising the steps of:
(1) putting the printed circuit board into lye and then heating it to 75-80°C to remove green oil on the printed circuit board;
(2) putting the printed circuit board with green oil removed into an acidic organic solvent to obtain some components and metals after soaking and heating, wherein the obtained components and metals can be reused after being cleaned respectively;
or, (2') etching the printed circuit board with green oil removed to obtain a copper ion recovery solution, and then putting the resulting substrate of copper clad laminate into an acidic organic solvent, soaking and heating to decompose epoxy resin composition to obtain a glass fabric and a decomposition product solution, wherein the obtained glass fabric can be reused after being cleaned;
optionally, (3') filtering the decomposition product solution of step (2') to obtain degradation liquid and solid fraction, adding alkali to the obtained degradation liquid for neutralization to precipitate the resin, and then filtering and separating to obtain a degraded resin which can be reused;
optionally, (4') separating each component of the solid fraction obtained in the step (3 ') based on different sizes thereof by sieves with different apertures, or based on different densities thereof by forming floating layer(s) and subsidence layer(s) in a same liquid due to different buoyancies, to separate filler, a small amount of powder and insoluble particles in the solid fraction, wherein the obtained filler can be reused after being cleaned.
